# EUROPÄISCHE PATENTSCHRIFT

(11) **EP 0 414 872 B1**
(45) Veröffentlichungstag und Bekanntmachung des Hinweises auf die Patenterteilung: **05.01.1994**
(21) Anmeldenummer: 90904298.8
(22) Anmeldetag: 15.03.1990
(51) Int. Cl.: H01J 5/32, H01J 9/32, G01L 9/00

(54) **ELEKTRISCH LEITENDE DURCHFÜHRUNG UND VERFAHREN ZU IHRER HERSTELLUNG**
ELECTRICALLY CONDUCTIVE FEEDTHROUGH AND PROCESS FOR MANUFACTURING IT
TRAVERSEE ELECTROCONDUCTRICE ET SON PROCEDE DE FABRICATION

(30) Priorität: 21.03.1989 DE 3909186
(43) Veröffentlichungstag der Anmeldung: 06.03.1991
(73) Patentinhaber: ENDRESS U. HAUSER GMBH U. CO., D-79689 Maulburg (DE)
(72) Erfinder: HEGNER, Frank, D-7850 Lörrach (DE); KLÄHN, Thomas, D-7800 Freiburg (DE)
(74) Vertreter: Morstadt, Volker, Dipl.-Ing.
(86) Internationale Anmeldenummer: EP9000419
(87) Internationale Veröffentlichungsnummer: WO9011610

(56) Entgegenhaltungen:
- EP-A- 0 351 701
- US-A- 3 436 109
- US-A- 4 345 299

## Beschreibung

Die Erfindung betrifft eine elektrisch leitende Durchführung mit den Merkmalen des Anspruchs 1, deren Verwendung mit den Merkmalen des Anspruchs 3 sowie deren Herstellungsverfahren mit den Merkmalen des Anspruchs 4 bzw. 6.

Nach dem Wortlaut des Anspruchs 1 ist die elektrisch leitende Durchführung durch eine Bohrung eines hochtemperaturbeständigen und vakuumtauglichen Isolierstoffteils, insbesondere aus Keramik, aus Glas oder aus einem Einkristall, als ein mit Aktivlot umhüllter und in die Bohrung eingelöteter Anschlussleiter ausgebildet, dessen thermischer Ausdehnungskoeffizient kleiner als der des Isolierungsstoffteils ist.

Nach dem Wortlaut des Anspruchs 3 wird die Durchführung bei einem Drucksensor mit einer Membran und einem Grundkörper, die gegenseitig beabstandete, ebene, zur Bildung mindestens eines Kondensators bzw. Dehnmessstreifens mit mindestens einer Leitschicht bzw. Widerstandsschicht versehene Innenflächen aufweisen, die mittels der Durchführung zur jeweiligen Rückseite hin kontaktiert sind, verwendet.

Bei dem Verfahren des Anspruchs 4 wird zum Herstellen einer Durchführung der umhüllte Leiter in die Bohrung eingesetzt und das so bestückte Isolierstoffteil in ein Vakuum eingebracht und bis zum vollständigen Durchschmelzen des Aktivlots erhitzt.

Bei dem Verfahren des Anspruchs 6 wird zum Herstellen einer Durchführung der umhüllte Leiter in die Bohrung eingesetzt und das so bestückte Isolierstoffteil in einer Gasatmosphäre mit einem Druck von höchstens 10 mbar (= 1 kPA) erhitzt.

Bei dem heute allgemein üblichen Verfahren zur Herstellung derartiger Durchführungen in Aluminiumoxid-Keramik wird nach der Zeitschrift "Solid State Technology", April 1985, Seiten 321 bis 324 eine Mn-Mo-Paste verwendet, die auf die Bohrungswand aufgebracht, anschliessend in feuchtem Wasserstoff bei hoher Temperatur (ca. 1500°C) eingesintert und anschliessend galvanisch, also elektrolytisch, mit Nickel beschichtet werden muss. Die Nickelschicht muss ebenfalls eingesintert werden. In die so metallisierte Bohrung kann dann ein Anschlussleiter eingelötet werden.

In Dokument US-A-3 436 109 ist eine elektrisch leitende Durchführung beschrieben, die einen durch eine Bohrung eines Isoliertstoffteils eingeführten Auschlussleiter aufweist. Eine Glaseinlage ist zwischen dem Auschlussleiter und der Bohrungswand vorgesehen; durch Schmelzen der Glasseinlage wird der Auschlussleiter fest und vakuumdicht mit dem Isolierstoffteil verbunden.

Dieses Herstellungsverfahren ist aufgrund der Mehrzahl der anzuwendenden Verfahrensschritte sehr aufwendig und teuer. Ausserdem ist die Prozessführung sehr kritisch, z.B. wegen der Explosionsgefährlichkeit des angewandten feuchten Wasserstoffs, was aufwendige Sicherheitsvorkehrungen und einen Spezialofen erfordert. Ausserdem ist bei langen, dünnen Bohrungen das Aufbringen der Mn-Mo-Paste nur in Handarbeit möglich, wobei ausserdem eine gleichmässige Dicke der aufgebrachten Schicht einzuhalten ist. Ferner ist Mn-Mo-Paste für höchstreine Aluminiumoxid-Keramik weniger gut geeignet.

Die Aufgabe der Erfindung besteht daher darin, eine allgemein für hochtemperaturbeständige und vakuumfeste Isolierstoffteile, insbesondere aus Keramik, aus Glas oder aus einem Einkristall, und nicht nur für Aluminiumoxid-Keramikteile geeignete Durchführung anzugeben, die in einem einzigen Hochtemperaturschritt herstellbar, billig, mechanisch stark belastbar und hochvakuumdicht ist.
Das bei der Erfindung verwendete Aktivlot besteht aus einem Lotmaterial, meistens einem Hartlot, wie Ag, Ag-Cu oder Ag-Cu-In, dem wenigstens ein reaktives Element, wie Ti, Zr, Be, Hf, oder Ta, zulegiert ist.

Dabei hat sich Ti als wirksamstes Legierungselement erwiesen. Das reaktive Element benetzt die Oberfläche der zu verlötenden Teile während des Lötens, so dass keine Metallisierung, wie z.B. die eingangs erwähnte Mn-Mo-Beschichtung, erforderlich ist.

Bei Oxidkeramik bewirkt die hohe Affinität des reaktiven Elements zum Sauerstoff eine Reaktion mit der Keramik, was zur Bildung von Mischoxiden und freien chemischen Valenzelektronen führt. Aktivlot kann jedoch auch bei Nichtoxidkeramik oder Glas ohne vorhergehende Metallisierung verwendet werden.

Bevorzugte Aktivlot-Legierungen sind duktil und enthalten 2 % bis 5 % Ti, das homogen in einer Matrix von z.B. Ag-Cu eingebettet ist. Sie können wie normale Hartlote verarbeitet werden, so dass also auch die Anschlussleiter damit ohne weiteres umhüllt werden können.

Typische im Handel befindliche Aktivlote sind die Legierungen Ag-Ti, Ag-Cu-Ti und Ag-Cu-In-Ti, deren Löttemperaturen zwischen 750°C und 1000°C liegen. Stufenlötungen (Abstufungen in den Schmelzpunkten) sind also auch bei Aktivloten möglich. Die Festigkeiten der Aktivlote sind identisch mit den Festigkeiten vergleichbarer Ti-freier Hartlote. Z.B. ist die Haftfestigkeit an Keramik grösser als die Festigkeit der Keramik selbst; im Zugversuch liegt daher der Bruch in der Keramik, nicht in der Grenzschicht Keramik-Lot.

Die Erhitzung des Aktivlots erfolgt vorzugsweise im Vakuum bei mindestens 0,01 µbar (= 1 mPa), besser im Bereich von 1 nbar (= 0,1 mPa). Sehr gutes Vakuum ist erforderlich, um Reaktionen des Ti mit dem Restgas zu vermeiden und eine gute Benetzung von z.B. Keramik zu erreichen.

Zur Erzielung bestimmter Lötergebnisse, beispielsweise zur Verminderung des Abdampfens des Lotes oder zur Reduktion von Oberflächenoxiden, kann es zweckmässig sein, den Aufheiz- bzw. Lötvorgang in einer definierten Gasatmosphäre aus inertem Gas und/oder Reaktivgas vorzunehmen. Die Partialdrücke dieser Gase liegen vorzugsweise unter 10 mbar (= 1 kPa).

Wie beim üblichen Löten wird auch beim Aktivlöten das Lot vollständig durchgeschmolzen. Die Löttemperatur muss aber beim Aktivlot zweckmässigerweise 70°C bis 100°C über der Liquidustemperatur liegen, damit eine optimale Reaktion des Ti mit z.B. Keramik erhalten wird. Dadurch wird eine hohe Festigkeit und Vakuumdichte erzielt.

Drucksensoren mit elektrischen Durchführungen nach der Erfindung zeichnen sich durch hohe mechanische Festigkeit, Belastbarkeit und Temperaturwechselbeständigkeit sowie durch eine sehr gute und sehr sichere Vakuumdichtheit bei einfachem Fertigungsverfahren aus. Auch kann die Qualität der Durchführung schnell und einfach mit Röntgendurchstrahlung geprüft werden.

Es ist überraschend, dass trotz der sehr unterschiedlichen Temperaturabhängigkeiten der Ausdehnungskoeffizienten von Metall und z.B. Keramik ein Aktivlot für die Einlötung von Durchführungen, insbesondere von Drucksensoren, verwendet werden kann.

Weitere Merkmale und Vorteile der Erfindung ergeben sich aus der folgenden Beschreibung eines Ausführbeispiels, das in der Zeichnung dargestellt ist.
Fig. 1 zeigt schematisch im Schnitt eine Durchführung,
Fig. 2 zeigt schematisch im Schnitt eine Weiterbildung der Durchführung nach Fig. 1,
Fig. 3 zeigt den Grundriss eines Drucksensors mit Durchführungen, und
Fig. 4 zeigt eine Schnittansicht des Drucksensors von Fig. 3 entlang der Schnittstelle A-B.

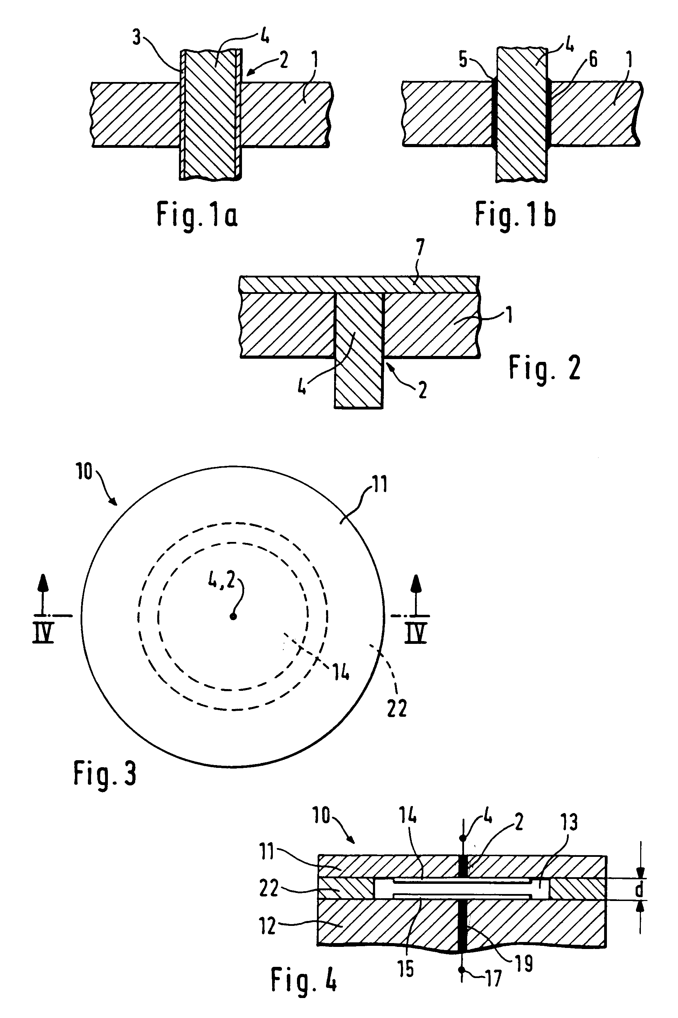

Die Fig. 1 zeigt schematisch im Schnitt eine Durchführung. In Fig. 1a ist der Zustand vor dem Erhitzen eines Isolierstoffteils 1 gezeigt, in dem in dessen Bohrung 2 ein mit Aktivlot 3 umhüllter Anschlussleiter 4 eingesetzt ist. Die Fig. 1b zeigt den erkalteten Zustand nach dem Aufschmelzen des Aktivlots; aus dem mit Aktivlot umhüllten Anschlussleiter 4 von Fig. 1a hat sich die diesen mit dem Isolierstoffteil 1 mittels der Lotschicht 5 vakuumdicht verbindende Durchführung 6 gebildet.

Einem Abreissen der Lotschicht vom Isolierstoffteil nach dem Abkühlen kann dadurch begegnet werden, dass der Anschlussleiter 4 aus einem Metall mit einem thermischen Ausdehnungskoeffizienten ist, der kleiner als der des Isolierstoffteils 1 ist. Beim Abkühlen schrumpfen dann Isolierstoffteil und Anschlussleiter etwa gleich stark, so dass die Aktivlotschicht praktisch spannungsfrei ist.

Es ist jedoch auch möglich, den Ausdehnungskoeffizienten des Anschlussleiters wesentlich kleiner als den des Isolierstoffteils zu machen. Dadurch wird erreicht, dass nach Abkühlen und dem Einschmelzen die Fügestelle mit dem Anschlussleiter und das Isolierstoffteil unter Druck stehen. Dies ist besonders wichtig, wenn das Isolierstoffteil aus sprödem Material besteht, da dieses keinerlei Zugspannung ausgesetzt werden darf.

Ein Zahlenbeispiel soll diesen Zusammenhang verdeutlichen. Der Ausdehnungskoeffizient von Aluminiumoxid-Keramik liegt bei etwa 7 ppm/K, der von Ag-Cu-Aktivlot bei etwa 19 ppm/K. Verwendet man nun einen Mo-Anschlussleiter, dessen Ausdehnungskoeffizient bei etwa 5 ppm/K liegt, so wird das Abreissen der Lotschicht von der Keramik sicher vermieden und die Vakuumdichtheit der Durchführung ist auch bei grösseren bis grossen Bohrungsdurchmessern gewährleistet.

Dieser Effekt tritt bei Verwendung von Wolfram mit einem Ausdehnungskoeffizienten bei Raumtemperatur von 4,5 ppm/K besonders stark hervor. Aber auch Tantal (6,5 ppm/K), Rhenium (5,9 ppm/K), Molybdän (5,0 ppm/K) oder Osmium (4,7 ppm/K) sind im Bedarfsfall geeignet. Wenn Zirkonium-Oxid in (10,5 ppm/K) als Isolierstoff verwendet wird, sind auch noch weitere Metalle mit niedrigerem Ausdehnungskoeffizienten als
10,5 ppm/K verwendbar.

Die Fig. 2 zeigt schematisch im Schnitt eine Weiterbildung der Durchführung von Fig. 1. Dabei wird wieder wie in Fig. 1a ein passendes Stück eines mit Aktivlot umhüllten Anschlussleiters 4 in die Bohrung 2 bündig mit deren einem Ende eingesetzt. Nach dem Erkalten wird die Leitbahn 7 aufgebracht, was z.B. durch Sputtern geschehen kann. Diese bildet mit der freiliegenden Oberfläche des Anschlussleiters 4 eine gut leitende elektrische und mechanische Verbindung.

Bei der Anordnungen nach den Fig. 1b, und 2 kann, wenn sie Teile eines Drucksensors sind, auf der jeweiligen Unterseite, z.B. ebenfalls durch Sputtern, eine Leitschicht aufgebracht werden, was jedoch der Uebersichtlichkeit wegen nicht veranschaulicht ist.

Bei der bevorzugten Verwendung der Durchführung hat der in Fig. 3 und 4 dargestellte Drucksensor 10 eine Membran 11 in Form einer kreisrunden Scheibe mit planparallelen Flächen, die rings um den Umfang mit einem kreisrunden Grundkörper 12 in einem definierten Abstand d zusammengefügt ist, so dass zwischen der ebenen Oberseite des Grundkörpers 12 und der gegenüberliegenden Fläche der Membran 11 eine Kammer 13 gebildet ist. Die Membran 11 und der Grundkörper 12 sind z.B. Keramikteile, deren Zusammensetzung voneinander verschieden sein kann. Die Membran 11 ist elastisch, so dass sie sich unter einem darauf einwirkenden Druck verformen kann. Der Grundkörper 12 kann massiv und starr sein, er kann aber auch, falls erwünscht, in gleicher Weise wie die Membran 11 als flache elastische Scheibe ausgebildet sein. Mittels des Formteils 22 sind Membran 11 und Grundkörper 12 mechanisch fest miteinander verbunden.

An den einander zugewandten Flächen der Membran 11 bzw. des Grundkörpers 12 sind innerhalb der Kammer 13 kreisförmige Leitschichten 14 bzw. 15 aus Metall angebracht, die sich gegenüberliegen. Mit der Leitschicht 14 ist der Anschlussleiter 4 verbunden, der gasdicht in der Bohrung 2 mittels der Durchführung fixiert und durch die Membran 11 nach aussen geführt ist.

In gleicher Weise ist mit der Leitschicht 15 des Grundkörpers 12 ein Anschlussleiter 17 verbunden, der gasdicht in einer Bohrung 19 mittels seiner Durchführung fixiert und durch den Grundkörper 12 nach aussen geführt ist. Die beiden Leitschichten 14, 15 bilden die Elektroden eines Kondensators, dessen Kapazität von dem Abstand zwischen den Leitschichten abhängt. Wenn sich die Membran 11 unter der Einwirkung eines Drucks verformt, ändert sich der Abstand zwischen den beiden Leitschichten 14, 15 und damit die Kapazität des Drucksensors. Diese kann mittels einer an die Anschlussleiters 4, 17 angeschlossenen elektronischen Schaltung gemessen werden und ist daher ein Mass für den auf die Membran 11 einwirkenden Druck. Durch Aufteilung der Leitschichten in eine innere Kreisfläche und eine äussere davon beabstandete Kreisringfläche können auch mehr als nur eine Kondensator realisiert werden.

Die Besonderheit des in Fig. 3 und 4 dargestellten Drucksensors besteht in der Art und Weise, wie die Durchführungen ausgebildet sind. Dafür sind die in Fig. 1 und 2 anhand des Isolierstoffteils 1 gezeigten Ausgestaltungen möglich, bei deren Aktivlot verwendet wird. Zur Herstellung der Verbindung der Teile 11, 12 wird ein thermisches Verfahren angewendet, das eine direkte Verbindung der Membran 11 und des Grundkörpers 12 mit dem Formteil 22, das ebenfalls aus Aktivlot besteht, ohne vorheriges Aufbringen einer Metallisierung ermöglicht.

Wenn bei der anhand der Fig. 2 erläuterten Weiterbildung auf der Fläche der Leitbahn 7 anstatt ihrer eine Dünn- oder Dickschichtschaltung, z.B. zur Realisierung der oben erwähnten Kapazitätsmessschaltung, vorgesehen werden soll, so ist zu deren elektrischer Verbindung mit dem Anschlussleiter 4 eine damit fluchtende Oeffnung in deren Substrat vorzusehen, durch die hindurch mittels eines üblichen Weichlots kontaktiert werden kann.

Obwohl die oben geschilderte Verwendung sich auf einen kapazitiven Drucksensor bezieht, können die Durchführungen nach der Erfindung auch bei resitiven Drucksensoren mit Erfolg angewendet werden.

## Patentansprüche

1. Elektrisch leitende Durchführung durch eine Bohrung (2) eines hochtemperaturbeständigen und vakuumtauglichen Isolierstoffteils (1), insbesondere aus Keramik, aus Glas oder aus einem Einkristall, welche Durchführung als ein mit Aktivlot umhüllter und in die Bohrung eingelöteter Anschlussleiter (4) ausgebildet ist, dessen thermischer Ausdehnungskoeffizient kleiner als der des Isolierstoffteils (1) ist.

2. Durchführung nach Anspruch 1 mit mindestens einer auf mindestens einer der Oberflächen des Isolierstoffteils (1) verlaufenden und den Anschlussleiter (4) kontaktierenden Leitschicht (14, 15) und/oder Leitbahn (7).

3. Verwendung einer Durchführung nach Anspruch 1 oder 2 bei einem Drucksensor (10) mit einer Membran (11) und einem Grundkörper (12), die gegenseitig beabstandete, ebene, zur Bildung mindestens eines Kondensators bzw. Dehnmessstreifens mit mindestens einer Leitschicht (14, 15) bzw. einer Widerstandsschicht versehene Innenflächen aufweisen, die mittels der Durchführung zur jeweiligen Rückseite hin kontaktiert sind.

4. Verfahren zum Herstellen einer Durchführung nach Anspruch 1 oder 2 bei dem der umhüllte Anschlussleiter (4) in die Bohrung (2) eingesetzt und das so bestückte Isolierstoffteil (1) in ein Vakuum eingebracht und bis zum vollständigen Durchschmelzen des Aktivlots erhitzt wird.

5. Verfahren nach Anspruch 4, bei dem das Vakuum einen Restgasdruck von weniger als 0,01 µbar (1 mPa) hat.

6. Verfahren zum Herstellen einer Durchführung nach Anspruch 1 oder 2 bei dem der umhüllte Anschlussleiter (4) in die Bohrung (2) eingesetzt und das so bestückte Isolierstoffteil (1) in einer Gasatmosphäre mit einem Druck von höchstens 10 mbar (1 kPa) erhitzt wird.

7. Verfahren nach Anspruch 6, bei dem die Gasatmosphäre aus einem inerten Gas besteht.

8. Verfahren nach Anspruch 6, bei dem die Gasatmosphäre aus einem Reaktivgas besteht.

9. Verfahren nach Anspruch 6, bei dem die Gasatmosphäre aus einem Gemisch von inerten und/oder reaktiven Gasen besteht.

## Claims

1. Electrically conductive feedthrough connection through a hole (2) of a high-temperature-resistant and vacuum-proof insulating part (1), particularly of ceramic, glass, or a single crystal, which feedthrough connection is designed as a terminal lead (4) covered with active solder and soldered into the hole, the terminal lead having a coefficient of thermal expansion less than that of the insulating part (1).

2. A feedthrough connection as claimed in claim 1, comprising at least one conductive layer (14, 15) and/or conductor path (6) provided on at least one of the surfaces of the insulating part (1) and making contact to the terminal lead (4).

3. Use of a feedthrough connection as claimed in claim 1 or 2 in a pressure sensor (10) comprising a diaphragm (11) and a substrate (12) which have spaced-apart, flat inner surfaces which are provided with at least one conductive layer (14, 15) or resistive layer for forming at least one capacitor or strain gage, respectively, and are electrically connected to the respective rear side via the feedthrough connection.

4. Method of manufacturing a feedthrough connection as claimed in claim 1 or 2 wherein
- the covered lead is inserted into the hole (2), and
- the thus equipped insulating part (1) is placed in a vacuum and heated until the active solder has completely melted.

5. A method as claimed in claim 4 wherein the vacuum has a residual-gas pressure of less than 10⁻⁵ mbars (= 10⁻³ Pa).

6. Method of manufacturing a feedthrough connection as claimed in claim 1 or 2 wherein
- the covered lead is inserted into the hole (2), and
- the thus equipped insulating part (1) is heated in a gas atmosphere with a pressure not exceeding 10 mbars (= 1 kPa).

7. A method as claimed in claim 6 wherein the gas atmosphere is constituted by an inert gas.

8. A method as claimed in claim 6 wherein the gas atmosphere is constituted by a reactive gas.

9. A method as claimed in claim 6 wherein the gas atmosphere consists of a mixture of inert and/or reactive gases.

## Revendications

1. Traversée électroconductrice à travers un perçage (2) d'une pièce en matière isolante (1) résistante aux hautes températures et au vide, en particulier faite de céramique, de verre ou d'un monocristal, sous la forme d'un conducteur de connexion (4) enrobé de soudure active et soudé dans le perçage et dont le coefficient de dilatation thermique est inférieur à celui de la pièce en matière isolante (1).

2. Traversée selon la revendication 1, comprenant au moins une couche conductrice (14, 15) et/ou une piste conductrice (7) s'étendant sur au moins une des surfaces de la pièce en matière isolante (1), et qui est en contact avec le conducteur de connexion (4).

3. Utilisation d'une traversée selon la revendication 1 ou 2, dans un capteur de pression (10) possedant une membrane (11) et un corps de base (12), qui présentent des surfaces intérieures planes, placées à distance l'une de l'autre, munies d'au moins une couche conductrice (14, 15) ou d'une couche résistante pour former au moins un condensateur ou une jauge de contrainte, chacune de ces surfaces étant en contact avec la face arrière respective par l'intermédiaire de la traversée.

4. Procédé de fabrication d'une traversée selon la revendication 1 ou 2, dans lequel on insère le conducteur enrobé (4) dans le perçage (2) et on met la pièce en matière isolante (1) ainsi équipée dans un vide et on la chauffe jusqu'à fusion totale de la soudure active.

5. Procédé selon la revendication 4, dans lequel le vide a une pression gazeuse résiduelle de moins de 0,01 µbar (1 mPa).

6. Procédé de fabrication d'une traversée selon la revendication 1 ou 2, dans lequel on insère le conducteur enrobé (4) dans le perçage (2) et on chauffe la pièce en matière isolante (1) ainsi équipée dans une atmosphère gazeuse sous une pression de 10 mbar (1 kPa) au maximum.

7. Procédé selon la revendication 6, dans lequel l'atmosphère gazeuse est composée d'un gaz inerte.

8. Procédé selon la revendication 6, dans lequel l'atmosphère gazeuse est composée d'un gaz réactif.

9. Procédé selon la revendication 6, dans lequel l'atmosphère gazeuse est composée d'un mélange de gaz inertes et/ou réactifs.
